# EUROPEAN PATENT APPLICATION

(11) **EP 4 766 053 A1**
(43) Date of publication of application: **24.06.2026**
(21) Application number: 24878508.1
(22) Date of filing: 12.06.2024
(51) Int. Cl.: H05K 7/20, G06F 1/20

(54) **ELECTRONIC APPARATUS**

(30) Priority: 17.10.2023 CN 202311348408
(71) Applicant: HUAWEI TECHNOLOGIES CO., LTD., Shenzhen 518129 (CN)
(72) Inventor: HE, Zhen, Shenzhen, Guangdong 518129 (CN); JIN, Qinghao, Shenzhen, Guangdong 518129 (CN); WANG, Yeren, Shenzhen, Guangdong 518129 (CN); CHEN, Jiming, Shenzhen, Guangdong 518129 (CN); LIU, Jiaju, Shenzhen, Guangdong 518129 (CN)
(74) Representative: Goddar, Heinz J.
(86) International application number: PCT/CN2024/098755
(87) International publication number: WO 2025/081855

(57) **Abstract**

Embodiments of this application provide an electronic device. The electronic device includes a device housing, a heat dissipation housing, a sealing member, a fan, and a heat-generating component. The heat dissipation housing is disposed on the device housing, the heat dissipation housing has an air duct, and the air duct has an air inlet and an air outlet. The fan is disposed facing the air duct. An air flow may be driven by the fan to enter the heat dissipation housing from the air inlet, flow inside the heat dissipation housing along the air duct, and finally flow out of the heat dissipation housing from the air outlet. The sealing member is movably connected to the heat dissipation housing, and the sealing member and the heat dissipation housing have a first position relationship and a second position relationship. When the sealing member and the heat dissipation housing are in the first position relationship, the sealing member avoids at least a part of the air inlet and at least a part of the air outlet. When the sealing member and the heat dissipation housing are in the second position relationship, the sealing member seals the air inlet and the air outlet.

## Description

### CROSS-REFERENCE TO RELATED APPLICATIONS

This application claims priority to Chinese Patent Application No. 202311348408.3, field with the China National Intellectual Property Administration on October 17, 2023 and entitled "ELECTRONIC DEVICE", which is incorporated herein by reference in its entirety.

### TECHNICAL FIELD

This application relates to the field of electronic technologies, and in particular, to an electronic device.

### BACKGROUND

As functions of an electronic device increase, application scenarios of the electronic device are increasingly diversified. In a scenario in which an electronic device runs three-dimensional software, game software, video editing software, or the like, power consumption of a device chip increases greatly. As the power consumption increases, the device chip generates a large amount of heat accordingly. If the heat generated by the device chip cannot be dissipated in time, a thermal failure of the entire device may be caused, and problems such as device breakdown and damage of an internal chip circuit may occur, affecting user experience. In the conventional technology, heat dissipation efficiency of a device chip is low, and a heat dissipation requirement in a special scenario cannot be met. As a result, a probability that a device is faulty due to a thermal failure increases.

### SUMMARY

Embodiments of this application provide an electronic device. The electronic device includes a heat dissipation housing and a fan disposed in the heat dissipation housing, to improve heat dissipation effect for a heat-generating component in the electronic device.

Embodiments of this application provide an electronic device. The electronic device includes a device housing, a heat dissipation housing, a fan, and a heat-generating component. The heat dissipation housing is disposed on the device housing, the heat dissipation housing has an air duct, and the air duct has an air inlet and an air outlet. The fan is located in the air duct. An air flow may be driven by the fan to enter the heat dissipation housing from the air inlet, flow inside the heat dissipation housing along the air duct, and finally flow out of the heat dissipation housing from the air outlet. The heat-generating component is located in the device housing, and the heat-generating component is thermally connected to the air duct. When the air flow passes through the air duct, the heat-generating component may exchange heat with the air flow, to reduce a temperature.

In addition to the foregoing components, the electronic device further includes a sealing member. The sealing member is movably connected to the heat dissipation housing, and the sealing member and the heat dissipation housing have a first position relationship and a second position relationship. When the sealing member and the heat dissipation housing are in the first position relationship, the sealing member avoids at least a part of the air inlet and at least a part of the air outlet, so that the air inlet and the air outlet are in a ventilation state. When the sealing member and the heat dissipation housing are in the second position relationship, the sealing member seals the air inlet and the air outlet, so that the air inlet and the air outlet are in a sealed state. The sealing member and the heat dissipation housing are controlled to move relative to each other, so that the air inlet and the air outlet may be switched between the ventilation state and the sealed state.

During specific application, in a scenario in which the heat-generating component generates a large amount of heat, the sealing member and the heat dissipation housing may be adjusted to the first position relationship, so that the air inlet and the air outlet are in the ventilation state, and then the fan is turned on to perform air-cooling heat dissipation on the heat-generating component. In a scenario in which the heat-generating component generates a small amount of heat, the sealing member and the heat dissipation housing may be adjusted to the second position relationship, so that the air inlet and the air outlet are in the sealed state, to prevent micro-dust, water vapor, and the like in an external environment from entering the electronic device. This improves dustproof and waterproof performance of the electronic device.

In some embodiments, the electronic device further includes a thermal conduction component. The thermal conduction component is thermally connected to the heat-generating component in the electronic device, and the thermal conduction component is at least partially located in the air duct. The thermal conduction component may conduct heat generated by the heat-generating component to the air duct, so that the heat can be dissipated to an external environment with flowing of an air flow. In addition, being connected to the thermal conduction component, the heat-generating component is arranged flexibly. For example, the heat-generating component may be arranged at a position close to the air duct, or may be arranged at a position far away from the air duct.

When the air duct is specifically disposed, the heat dissipation housing may have a plurality of air ducts, and at least one fan may be disposed in each air duct. For any two of the plurality of air ducts, extension paths of the two air ducts are different, but air inlets of the two air ducts may be the same or different. Similarly, the air outlets of the two air ducts may be the same or different. Specifically, for ease of description, the two air ducts are respectively denoted as a first air duct and a second air duct. In a possible deposition manner, the first air duct and the second air duct have a same air inlet, and the first air duct and the second air duct have different air outlets. In another possible deposition manner, the first air duct and the second air duct have different air inlets, and the first air duct and the second air duct have a same air outlet. In still another possible deposition manner, the first air duct and the second air duct have different air inlets, and the first air duct and the second air duct also have different air outlets.

When the air duct is specifically formed, a plurality of partition plates may be disposed in the heat dissipation housing, and the air duct is enclosed by the partition plates. Alternatively, a ventilation pipe may be disposed in the heat dissipation housing, and the air duct is formed through the ventilation pipe. Certainly, the air duct may alternatively be formed in another manner, which is not listed one by one in this application. The air duct may guide an air flow to flow along a specified path, thereby improving heat dissipation effect for the heat-generating component. In addition, the air duct may be isolated from an internal environment of the device housing, thereby improving dustproof and waterproof performance of the device housing.

When the heat dissipation housing is specifically disposed, the heat dissipation housing may protrude from a surface of the device housing, and a transparent window is disposed on the heat dissipation housing. The transparent window allows light to pass through. In a possible disposition form, the heat dissipation housing includes a side wall and a top wall, where the side wall of the heat dissipation housing is connected to the device housing, and the transparent window is disposed on the top wall of the heat dissipation housing. In addition, the electronic device further includes a camera module, where the camera module has a light incident surface, and a projection of at least a part of the light incident surface in a third direction is located in a projection of the transparent window in the third direction. The third direction is perpendicular to a plane on which the transparent window is located. In a working procedure of the camera module, light in an external environment may be incident to the light incident surface through the transparent window, enter the camera module from the light incident surface, and form an image after image processing. When the transparent window is specifically disposed, a transparent film may be disposed at the transparent window, to block external dust, water vapor, and the like from entering.

In the foregoing technical solution, the heat dissipation housing forms an accommodation cavity on a side facing the device housing. The accommodation cavity may be configured to accommodate the fan, or may be configured to dispose the air duct, so that the fan, the air duct, and the like do not occupy internal space of the device housing, or occupy only small space of the device housing. The accommodation cavity may also provide a part of additional accommodation space for some components with complex structures in the device housing. For example, when the camera module is specifically arranged, at least a part of the camera module may be located in the accommodation cavity, so that the camera module has large mounting space, and it is possible to use the camera module with better performance and a more complex structure, to improve image-shooting quality of the electronic device.

When the air inlet and the air outlet are provided in a wall surface of the heat dissipation housing, both the air inlet and the air outlet may be provided in the side wall. Alternatively, one of the air inlet and the air outlet may be provided in the side wall, and the other may be provided in the top wall. For example, the air inlet may be provided in the top wall, and the air outlet may be provided in the side wall.

In a specific technical solution, the heat dissipation housing has a plurality of air inlets and a plurality of air outlets, the plurality of air inlets are spaced apart in a first direction, and the plurality of air outlets are spaced apart in a second direction. The sealing member includes a first sealing member and a second sealing member. The first sealing member extends in the first direction, the first sealing member has a plurality of first air vents in the first direction, and there is a first spacer between two adjacent first air vents. The second sealing member extends in the second direction, the second sealing member has a plurality of second air vents in the second direction, and there is a second spacer between two adjacent second air vents.

During a specific connection, the heat dissipation housing may be slidably connected to the first sealing member in the first direction, and the heat dissipation housing is slidably connected to the second sealing member in the second direction. The heat dissipation housing and the sealing member slide relative to each other, so that a position relationship between the heat dissipation housing and the sealing member may be adjusted, to change ventilation conditions of the air inlet and the air outlet. Specifically, in a process in which the sealing member and the heat dissipation housing slide relative to each other, when the sealing member and the heat dissipation housing are in the first position relationship, the air inlet and the first air vent at least partially overlap, and the air outlet and the second air vent at least partially overlap. In this case, both the air inlet and the air outlet are in the ventilation state. When the sealing member and the heat dissipation housing are in the second position relationship, the first spacer seals the air inlet, and the second spacer seals the air outlet. In this case, both the air inlet and the air outlet are in the sealed state.

In another specific technical solution, the heat dissipation housing has a first central axis, and the air inlet and the air outlet are provided around the first central axis in a circumferential direction. The sealing member is of a ring-shaped structure, and the ring-shaped structure is disposed around the first central axis. The ring-shaped structure has a plurality of air vents, the plurality of air vents are sequentially spaced apart in the circumferential direction, and there is a spacer between two adjacent air vents.

During a specific connection, the sealing member may be rotatably connected to the heat dissipation housing, so that the sealing member and the heat dissipation housing can rotate relative to each other around the first central axis. In a process in which the sealing member and the heat dissipation housing rotate relative to each other around the first central axis, a position relationship between the sealing member and the heat dissipation housing changes, and ventilation of the air inlet and the air outlet also changes.

Specifically, the plurality of air vents include a third air vent and a fourth air vent, and the spacer includes a third spacer and a fourth spacer. When the sealing member and the heat dissipation housing have the first position relationship, the third air vent and the air inlet at least partially overlap, and the fourth air vent and the air outlet at least partially overlap. In this case, both the air inlet and the air outlet are in the ventilation state. When the sealing member and the heat dissipation housing have the second position relationship, the third spacer seals the air inlet, and the fourth spacer seals the air outlet. In this case, both the air inlet and the air outlet are in the sealed state.

In still another specific technical solution, the heat dissipation housing has a first central axis, and the air inlet and the air outlet are provided around the first central axis in a circumferential direction. The sealing member is of a ring-shaped structure, the ring-shaped structure is disposed around the first central axis, and the ring-shaped structure is slidably connected to the heat dissipation housing along the first central axis. In other words, the ring-shaped structure and the heat dissipation housing may be driven by an external force to perform a lifting motion along the first central axis. In addition, the ring-shaped structure and the heat dissipation housing have the first position relationship and the second position relationship. When the sealing member and the heat dissipation housing have the first position relationship, the ring-shaped structure avoids the air inlet and the air outlet. In this case, both the air inlet and the air outlet are in the ventilation state. When the sealing member and the heat dissipation housing have the second position relationship, the ring-shaped structure seals the air inlet and the air outlet. In this case, both the air inlet and the air outlet are in the sealed state.

To drive the heat dissipation housing and the sealing member to move relative to each other, the electronic device further includes a drive component, and the drive component may be connected to the heat dissipation housing or the sealing member, to drive the heat dissipation housing and the sealing member to move relative to each other. In a specific technical solution, the drive component is connected to the sealing member, and the drive component is configured to drive the sealing member to move, so that the sealing member avoids at least a part of the air inlet and at least a part of the air outlet, or the sealing member completely seals the air inlet and the air outlet. When the sealing member is specifically disposed, the heat dissipation housing may protrude from a surface of the device housing, and a side that is of the heat dissipation housing and that faces the device housing forms an accommodation cavity, so that the sealing member is disposed in the accommodation cavity. The sealing member is disposed in the accommodation cavity, so that the sealing member is not exposed to the external environment. This helps ensure cleanliness of a gap between the sealing member and the heat dissipation housing, and ensures smooth relative movement between the sealing member and the heat dissipation housing. In addition, after the sealing member is disposed inside the heat dissipation housing, appearance effect of the electronic device can be further improved.

When the electronic device is being used, the sealing member and the heat dissipation housing are adjusted to the first position relationship, and the fan is started, so that an air flow enters the heat dissipation housing, to cool the heat-generating component in an air-cooling heat dissipation mode. During specific implementation, the electronic device may be enabled to automatically run in the air-cooling heat dissipation mode in a plurality of manners. In a possible technical solution, the electronic device further includes a controller and an operation part, and the controller is separately connected to the operation part, the drive component, and the fan. The operation part has a first trigger state, and the controller is configured to: when the operation part is in the first trigger state, control the drive component to drive the heat dissipation housing and the sealing member to move relative to each other, so that the heat dissipation housing and the sealing member are in the first position relationship, and the fan is started.

During specific disposition, the operation part may be a control bar located on a housing frame. When the heat-generating component needs to dissipate heat, a user may press the control bar to switch to the first trigger state. Alternatively, the operation part may be a control window located on a touchscreen of the electronic device. When the heat-generating component needs to dissipate heat, a user may tap the window to switch to the first trigger state.

In the foregoing technical solution, in an implementation process, the user needs to subjectively determine whether to run the air-cooling heat dissipation mode to dissipate heat for the heat-generating component. When the user considers that the air-cooling heat dissipation mode needs to be run to dissipate heat for the heat-generating component, the user may trigger the operation part, so that the operation part is in the first trigger state, and the controller can control the drive component to drive the sealing member. In this way, the drive component drives the sealing member and the heat dissipation housing to move relative to each other, so that the heat dissipation housing and the sealing member are in the first position relationship, and the fan is controlled to start.

In another possible technical solution, a detection component may be further disposed, and the detection component detects a first running indicator of the heat-generating component. When the first running indicator is greater than a first threshold, it indicates that the heat-generating component generates a large amount of heat, and the air-cooling heat dissipation mode needs to be run to dissipate heat for the heat-generating component. During specific implementation, the detection component is connected to the controller, and the controller is configured to: when the first running indicator is greater than the first threshold, control the drive component to drive the heat dissipation housing and the sealing member to move relative to each other, so that the heat dissipation housing and the sealing member are in the first position relationship, and the fan is started. The first running indicator includes but is not limited to a power consumption indicator or a temperature indicator of the heat-generating component.

In still another possible technical solution, the heat-generating component is specifically a chip, and the chip is configured to carry running of a first application. In a running process of the first application, the chip generates a large amount of heat, and the air-cooling heat dissipation mode needs to be run to dissipate heat for the chip. During specific implementation, the controller is configured to: when the first application is in a running state, control the drive component to drive the heat dissipation housing and the sealing member to move relative to each other, so that the heat dissipation housing and the sealing member are in the first position relationship, and the fan is started. The first application includes but is not limited to an application such as three-dimensional modeling, a game, or video editing.

During specific implementation, when any one of "the operation part is in the first trigger state", "the detection component detects that the first running indicator is greater than the first threshold", and "the first application is in the running state" is met, the controller may control the drive component, so that the drive component drives the heat dissipation housing and the sealing member to move relative to each other. In this way, the heat dissipation housing and the sealing member are in the first position relationship, and the fan is started, to perform air-cooling heat dissipation on the heat-generating component.

When the electronic device is being used, the electronic device may alternatively be enabled to automatically disable the air-cooling heat dissipation mode in a plurality of manners. For example, the operation part further has a second trigger state, and the controller is configured to: when the operation part is in the second trigger state, control the drive component to drive the heat dissipation housing and the sealing member to move relative to each other, so that the heat dissipation housing and the sealing member are in the second position relationship, and the fan is turned off. For another example, the controller may also be configured to: when the first running indicator is less than or equal to the first threshold, control the drive component to drive the heat dissipation housing and the sealing member to move relative to each other, so that the heat dissipation housing and the sealing member are in the second position relationship, and the fan is turned off. For another example, the controller may be further configured to: when the first application is in a stop state, control the drive component to drive the heat dissipation housing and the sealing member to move relative to each other, so that the heat dissipation housing and the sealing member are in the second position relationship, and the fan is turned off.

During specific implementation, when "the operation part is in the second trigger state", "the detection component detects that the first running indicator is less than or equal to the first threshold", and "the first application is in a closed state" are all satisfied at the same time, the controller may control the drive component, so that the drive component drives the heat dissipation housing and the sealing member to move relative to each other. In this way, the heat dissipation housing and the sealing member are in the second position relationship, and the fan is turned off, to stop air-cooling heat dissipation on the heat-generating component.

In a specific deposition manner, the electronic device further includes a display, and the display is disposed on a surface of the housing. Because a side that is of the housing and that is away from the display has large mounting space, when a heat dissipation housing is specifically disposed, the heat dissipation housing may be disposed on the side that is of the housing and that is away from the display.

### BRIEF DESCRIPTION OF DRAWINGS

FIG. 1 is a diagram of an overall structure of an electronic device according to an embodiment of this application;
FIG. 2 is a diagram of an overall structure of another electronic device according to an embodiment of this application;
FIG. 3 is an A-A sectional view of an electronic device according to an embodiment of this application;
FIG. 4 is an A-A sectional view of another electronic device according to an embodiment of this application;
FIG. 5 is a diagram of a layout of an air duct according to an embodiment of this application;
FIG. 6 is a diagram of another layout of an air duct according to an embodiment of this application;
FIG. 7 is a diagram of a combination of a sealing member and a heat dissipation housing according to an embodiment of this application;
FIG. 8 is a diagram of another combination of a sealing member and a heat dissipation housing according to an embodiment of this application; and
FIG. 9 is a diagram of still another combination of a sealing member and a heat dissipation housing according to an embodiment of this application.

Reference numerals:
1: device housing; 2: heat dissipation housing; 21: side wall; 22: top wall; 201: air duct; 202: air inlet; 203: air outlet; 204: transparent window; 3: fan; 4: thermal conduction component; 41: substrate; 42: heat dissipation fin; 43: heat pipe; 5: sealing member; 51: first sealing member; 52: second sealing member; 501: first air vent; 502: second air vent; 503: third air vent; 504: fourth air vent; 511: first spacer; 512: second spacer; 513: third spacer; 514: fourth spacer; 6: heat-generating component; 7: camera module; and 701: light incident surface.

### DESCRIPTION OF EMBODIMENTS

To make the objectives, technical solutions, and advantages of this application clearer, the following further describes this application in detail with reference to the accompanying drawings.

Terms used in the following embodiments are merely intended to describe specific embodiments, but are not intended to limit this application. The terms "one", "a", "the", "the foregoing", and "this" of singular forms used in this specification and the appended claims of this application are also intended to include expressions such as "one or more", unless otherwise specified in the context clearly.

Reference to "an embodiment", "some embodiments", or the like described in the specification of this application means that a specific feature, structure, or characteristic described with reference to the embodiment is included in one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

In addition, in the specification of this application, the terms "first" and "second" are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of the present disclosure, unless otherwise specifically limited, "a plurality of" means two or more.

To facilitate understanding of an electronic device provided in embodiments of this application, the following first describes an application scenario of the electronic device. The electronic device in this application may be specifically a mobile phone, a tablet computer, an e-paper book, or the like. The electronic device may have a plurality of functions such as communication, entertainment, and image shooting. In addition, with development of technologies, functions of the electronic device are continuously optimized to satisfy higher requirements of consumers. A plurality of electronic components, such as a chip, a battery, and a sensor, are disposed inside the electronic device. When the electronic components work normally, the electronic device can implement corresponding functions, and a user can obtain good use experience. One factor that affects normal operation of the electronic component is an overheat problem of the electronic component. When the electronic component generates a large amount of heat and heat dissipation efficiency is low, because heat cannot be dissipated in time, a temperature of the electronic component is high, and performance and a service life of the electronic component are reduced. This affects normal operation of the electronic device. In view of this, this application provides an electronic device. The electronic device includes a heat dissipation housing and a fan disposed in the heat dissipation housing, to resolve a heat dissipation problem of some electronic components in the electronic device. The following describes the electronic device in the technical solutions of this application by using embodiments with reference to the accompanying drawings.

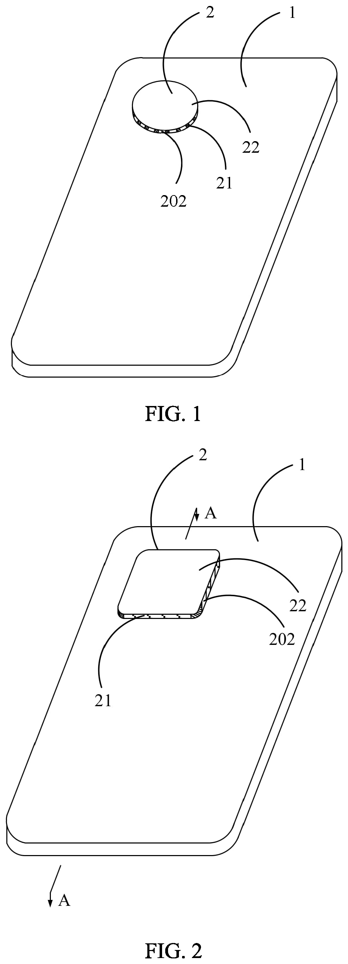

FIG. 1 is a diagram of an overall structure of an electronic device according to an embodiment of this application. As shown in FIG. 1, in an embodiment, the electronic device includes a device housing 1 and a heat dissipation housing 2. The device housing 1 is a housing structure having accommodation space, and the device housing 1 may accommodate some electronic components disposed to achieve various functions of the electronic device. The heat dissipation housing 2 is disposed on the device housing 1. In an optional embodiment, from an appearance perspective, a surface of the heat dissipation housing 2 may be flush with a surface of the device housing 1, or may protrude from the surface of the device housing 1. In a preparation procedure, the heat dissipation housing 2 and the device housing 1 may be prepared by using an integrated molding process. Specifically, the integrated molding process includes but is not limited to a stamping process, an injection molding process, and the like. Alternatively, in another embodiment, the heat dissipation housing 2 and the device housing 1 may be separately prepared, and are connected through a connection structure. For example, the heat dissipation housing 2 and the device housing 1 may be bonded through an adhesive layer. For another example, the heat dissipation housing 2 and the device housing 1 may alternatively be fastened through a fastener or a snap-fit structure.

A position of the heat dissipation housing 2 is not limited. To enable the heat dissipation housing 2 to have large mounting space, during arrangement, the heat dissipation housing 2 may be disposed on a side that is of the device housing 1 and that has a large area. In a specific embodiment, the electronic device includes a display, and the display is located on the surface of the device housing 1. When the heat dissipation housing 2 is specifically disposed, the heat dissipation housing 2 may be disposed on a side that is of the device housing 1 and that is away from the display.

Still refer to FIG. 1. In an embodiment, the heat dissipation housing 2 protrudes from the surface of the device housing 1, and an orthographic projection of an outer peripheral contour of the heat dissipation housing 2 on the surface of the device housing 1 is a circle. FIG. 2 is a diagram of an overall structure of another electronic device according to an embodiment of this application. As shown in FIG. 2, in another embodiment, a heat dissipation housing 2 alternatively protrudes from a surface of a device housing 1, and an orthographic projection of an outer peripheral contour of the heat dissipation housing 2 on the surface of the device housing 1 is a rectangle. In another embodiment, in addition to the foregoing shapes, the orthographic projection of the outer peripheral contour of the heat dissipation housing 2 on the surface of the designed housing 1 may alternatively be another shape. This is not listed one by one in this application.

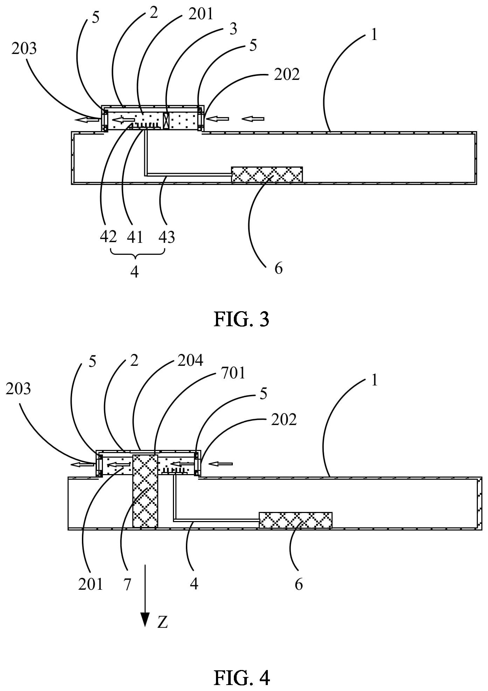

FIG. 3 is an A-A sectional view of an electronic device according to an embodiment of this application. As shown in FIG. 3, in an embodiment, the electronic device further includes a heat-generating component 6, and the heat-generating component 6 is disposed on the device housing 1. The heat-generating component 6 is a type of electronic component that generates a large amount of heat in a working procedure of the electronic device. If the heat generated by the heat-generating component 6 is not dissipated in time, normal working of the heat-generating component 6 may be affected, and consequently the electronic device is faulty. Specifically, the heat-generating component 6 includes but is not limited to a chip or a battery.

Still refer to FIG. 3. In the foregoing embodiment, an air duct 201 is disposed in the heat dissipation housing 2, and the air duct 201 has an air inlet 202 and an air outlet 203. In addition, the electronic device further includes a fan 3. The fan 3 is disposed on the heat dissipation housing 2, and the fan 3 is disposed facing the air duct 201. When the fan 3 is specifically mounted, the fan 3 may be mounted at two ends of the air duct 201, or the fan 3 may be mounted in the air duct 201 and located between the two ends of the air duct 201. An air flow may be driven by the fan 3 to enter the heat dissipation housing 2 from the air inlet 202, flow inside the heat dissipation housing 2 along the air duct 201, and finally flow out of the heat dissipation housing 2 from the air outlet 203. The air duct 201 is thermally connected to the heat-generating component 6 in the device housing 1. When an air flow passes through the air duct 201, the air flow may exchange heat with the heat-generating component 6, to reduce a temperature of the heat-generating component 6, thereby achieving heat dissipation effect for the heat-generating component 6. In addition, because the air inlet 202, the air outlet 203, and the air duct 201 are all disposed on the heat dissipation housing 2, a flow path of the air flow is short, so that wind resistance can be reduced, air circulation can be accelerated, and heat dissipation effect for the heat-generating component 6 can be improved.

To conduct heat generated by the heat-generating component 6 to the air duct 201, the heat-generating component 6 has a plurality of possible disposition manners. In a possible deposition manner, a part of the heat-generating component 6 may be disposed in the air duct 201, so that the air flow may flow through a surface of the heat-generating component 6 in a process of passing through the air duct 201, to directly exchange heat with the heat-generating component 6. In another possible deposition manner, the heat-generating component 6 may alternatively be disposed outside the air duct 201, and the heat-generating component 6 is thermally connected to an outer wall surface of the air duct 201, so that in a process of passing through the air duct 201, the air flow may indirectly exchange heat with the heat-generating component 6 through a wall surface of the air duct 201. In still another possible deposition manner, as shown in FIG. 3, the electronic device may further include a thermal conduction component 4, and the thermal conduction component 4 is thermally connected to the heat-generating component 6, so that heat generated by the heat-generating component 6 can be conducted to the thermal conduction component 4. To enable the thermal conduction component 4 to conduct heat to the air flow in the air duct 201, at least a part of the thermal conduction component 4 may be located in the air duct 201, or at least a part of the thermal conduction component 4 may be thermally connected to an outer wall surface of the air duct 201. In the foregoing deposition manner, the heat generated by the heat-generating component 6 may be conducted to the air duct 201 through the thermal conduction component 4, and then dissipated to an external environment by using the air flow. In a specific embodiment, the thermal conduction component 4 may be understood as a heat sink thermally connected to the heat-generating component 6. The thermal conduction component 4 may be disposed, so that a mounting position of the heat-generating component 6 is flexible. For example, the heat-generating component 6 may be mounted at a position close to the air duct 201, or may be mounted at a position far away from the air duct 201.

In a specific embodiment, there are a plurality of options for a structure of the thermal conduction component 4. For example, in a possible structure, the thermal conduction component 4 includes a substrate 41 and a plurality of heat dissipation fins 42 disposed on a surface of the substrate 41. The substrate 41 is thermally connected to the heat-generating component 6, and at least a part of a region of the heat dissipation fin 42 is located in the air duct 201. The heat dissipation fin 42 has a large heat exchange area. In a process in which the air flow flows through the air duct 201, the air flow may exchange heat with the heat dissipation fins 42, to reduce a temperature of the heat-generating component 6. In another possible structure, as shown in FIG. 3, the thermal conduction component 4 includes a substrate 41, a heat dissipation fin 42, and a heat pipe 43. One end of the heat pipe 43 is connected to the heat-generating component 6, and the other end of the heat pipe 43 is connected to the substrate 41. The heat dissipation fin 42 is disposed on a surface of the substrate 41, and at least a part of a region of the heat dissipation fin 42 is located in the air duct 201. The heat pipe 43 may conduct the heat generated by the heat-generating component 6 to the heat dissipation fin 42, and the heat dissipation fin 42 exchanges heat with the air flow to dissipate heat for the heat-generating component 6. The heat pipe 43 generally includes a tube shell, a porous capillary core, and a working medium. An end that is of the heat pipe 43 and that is connected to the heat-generating component 6 is an evaporation end, and an end that is of the heat pipe 43 and that is connected to the substrate 41 is a condensation end. When the evaporation end is heated, a liquid working medium in the porous capillary core is rapidly evaporated into a gaseous state, the gaseous working medium flows to the condensation end under a small pressure difference, and is re-condensed into a liquid state after releasing heat at the condensation end, and the liquid working medium flows back to the evaporation end under a capillary force, to complete one cycle. In a process of repeatedly circulating the working medium between the evaporation end and the condensation end, the heat generated by the heat-generating component 6 is continuously conducted to the substrate 41, and the substrate 41 conducts the heat to the air flow through the heat dissipation fin 42, to dissipate heat for the heat-generating component 6.

Certainly, the thermal conduction component 4 may alternatively be of another structure, which is not listed one by one in this application.

FIG. 4 is an A-A sectional view of another electronic device according to an embodiment of this application. As shown in FIG. 4, in another embodiment, the heat dissipation housing 2 protrudes from a surface of the device housing 1, and a transparent window 204 is disposed on the heat dissipation housing 2. The transparent window 204 allows light to pass through. A transparent film may be disposed at the transparent window 204, to block external dust and water vapor from entering the electronic device. In addition, the electronic device further includes a camera module 7. The camera module 7 has a light incident surface 701, and a projection of at least a part of the light incident surface 701 in a third direction Z is located in a projection of the transparent window 204 in the third direction Z. The third direction Z is perpendicular to a plane on which the transparent window 204 is located. In a working procedure of the camera module 7, light in an external environment may be incident to the light incident surface 701 through the transparent window 204, enter the camera module 7 from the light incident surface 701, and form an image after image processing.

Still refer to FIG. 2. The heat dissipation housing 2 includes a side wall 21 and a top wall 22. The side wall 21 is connected to the top wall 22, and the side wall 21 is further connected to the device housing 1. The transparent window 204 may be specifically disposed on the top wall 22 of the heat dissipation housing 2, and the third direction Z is specifically a thickness direction of the electronic device. In addition, an accommodation cavity may be enclosed by the side wall 21 and the top wall 22, and the accommodation cavity may be configured to accommodate the fan 3, or may be configured to form the air duct 201, so that components such as the fan 3 and the air duct 201 do not occupy internal space of the device housing 1, or components such as the fan 3 and the air duct 201 occupy only small space of the device housing 1. This helps the device housing 1 achieve a thin design requirement. In addition, when the camera module 7 is mounted, at least a part of the camera module 7 may be accommodated in the accommodation cavity, so that the camera module 7 has large mounting space, and it is possible to use the camera module 7 with better performance and a more complex structure, to improve image-shooting quality of the electronic device.

It may be understood that, during specific layout, the air duct 201 may avoid the camera module 7, and the air flow in the air duct 201 may be isolated from the camera module 7, to prevent water vapor and the like from spreading to the camera module 7 and affecting normal operation of the camera module 7.

When the air inlet 202 and the air outlet 203 are provided in a wall surface of the heat dissipation housing 2, there are a plurality of possible deposition manners. In a possible deposition manner, both the air inlet 202 and the air outlet 203 may be provided in the side wall 21. Providing the air inlet 202 and the air outlet 203 in the side wall 21 helps reduce wind resistance and make an air flow circulation path smoother, and may further fully use an area of a region of the side wall 21 of the heat dissipation housing 2, and improve overall appearance effect. In another possible deposition manner, alternatively, one of the air inlet 202 and the air outlet 203 may be provided in the side wall 21, and the other may be provided in the top wall 22. For example, the air inlet 202 may be provided in the top wall 22, and the air outlet 203 may be provided in the side wall 21. In still another possible deposition manner, both the air inlet 202 and the air outlet 203 may alternatively be provided in the top wall 22.

Specifically, when the air duct 201 is formed in the heat dissipation housing 2, a plurality of partition plates may be disposed in the heat dissipation housing 2, and the air duct 201 is enclosed by the partition plates. Alternatively, a ventilation pipe may be disposed in the heat dissipation housing 2, and the air duct 201 is formed through the ventilation pipe. The air duct 201 may guide the air flow to flow along a specified path, thereby improving heat dissipation effect for the heat-generating component 6. In addition, the air duct 201 may be isolated from an internal environment of the device housing 1, thereby improving dustproof and waterproof performance of the device housing 1.

A quantity of air ducts 201 is not limited, and there may be one or more air ducts 201. For any air duct 201, a quantity of air inlets 202 of the air duct 201 may be one or more. This is not limited in this application. Similarly, a quantity of air outlets 203 of the air duct 201 may be one or more. This is not limited in this application. It may be understood that the air duct 201 may have one air inlet 202 or one air outlet 203 with a large opening, or may have a plurality of air inlets 202 or a plurality of air outlets 203 with small openings. When the air duct 201 has a plurality of air inlets 202 with small openings or a plurality of air outlets 203 with small openings, two adjacent air inlets 202 are spaced apart, and two adjacent air outlets 203 are spaced apart.

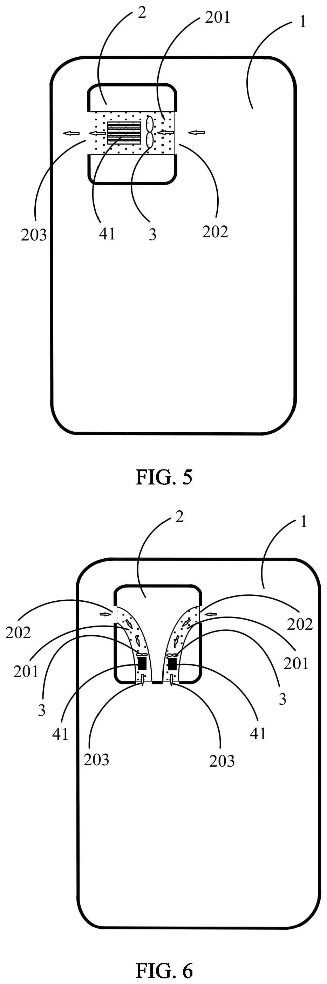

FIG. 5 is a diagram of a layout of an air duct according to an embodiment of this application. As shown in FIG. 5, in an embodiment, the heat dissipation housing 2 has one air duct 201, and an air inlet 202 and an air outlet 203 of the air duct 201 are provided on two opposite sides of the heat dissipation housing 2.

FIG. 6 is diagram of another layout of an air duct according to an embodiment of this application. As shown in FIG. 6, in an embodiment, the heat dissipation housing 2 has a plurality of air ducts 201, and each air duct 201 is provided with at least one fan 3. When the electronic device is being used, all fans 3 in the plurality of air ducts 201 may be turned on, so that an air flow passes through each air duct 201. Alternatively, fans 3 in a part of air ducts 201 may be turned on, and fans 3 in a part of air ducts 201 may be turned off selectively. Alternatively, all fans 3 in the plurality of air ducts 201 may be turned off. On and off of the fan 3 may be specifically configured based on heat generation amount of the heat-generating component 6, so that a heat dissipation capability of the heat dissipation housing 2 matches the heat generation amount of the heat-generating component 6.

In the plurality of air ducts 201 included in the heat dissipation housing 2, extension paths of the air ducts 201 are different, and air inlets 202 of the different air ducts 201 may be the same or different. Similarly, air outlets 203 of different air ducts 201 may be the same or different. For ease of description, a first air duct and a second air duct are used to represent any two air ducts 201 in the plurality of air ducts 201. In a possible deposition manner, the first air duct and the second air duct have a same air inlet 202, and the first air duct and the second air duct have different air outlets 203. The foregoing deposition manner may also be understood as that the air inlet 202 of the first air duct and the air inlet 202 of the second air duct are provided at a same position of the heat dissipation housing 2 and overlap each other. The air outlet 203 of the first air duct and the air outlet 203 of the second air duct are provided at different positions of the heat dissipation housing 2. In a heat dissipation process, an air flow in an external environment may be driven by the fan 3 to enter the heat dissipation housing 2 through a same air inlet 202, and then be divided into two air flows. One air flow enters the first air duct, and the other air flow enters the second air duct. The two air flows flow along different paths, and finally flow out of the heat dissipation housing 2 through different air outlets 203.

In another possible deposition manner, the first air duct and the second air duct have different air inlets 202, and the first air duct and the second air duct have a same air outlet 203. The foregoing deposition manner may also be understood as that the air inlet 202 of the first air duct and the air inlet 202 of the second air duct are provided at different positions of the heat dissipation housing 2. The air outlet 203 of the first air duct and the air outlet 203 of the second air duct are provided at a same position of the heat dissipation housing 2, and overlap each other. In a heat dissipation process, two air flows in an external environment are driven by the fan 3 to enter the heat dissipation housing 2 through different air inlets 202, and then flow along the first air duct and the second air duct respectively. Finally, the two air flows flow out of the heat dissipation housing 2 through a same air outlet 203.

In still another possible deposition manner, the first air duct and the second air duct have different air inlets 202, and the first air duct and the second air duct also have different air outlets 203. The foregoing deposition manner may also be understood as that the air inlet 202 of the first air duct and the air inlet 202 of the second air duct are provided at different positions of the heat dissipation housing 2. The air outlet 203 of the first air duct and the air outlet 203 of the second air duct are also provided at different positions of the heat dissipation housing 2. In a heat dissipation process, two air flows in an external environment are driven by the fan 3 to enter the heat dissipation housing 2 through different air inlets 202, and then flow along the first air duct and the second air duct respectively. Finally, the two air flows flow out of the heat dissipation housing 2 through different air outlets 203.

During specific disposition, the air inlet 202 and the air outlet 203 of the air duct 201, and an extension path of the air duct 201 may be laid out based on an overall architecture distribution of the electronic device.

It may be understood that, in a scenario in which the heat-generating component 6 is dissipated, both the air inlet 202 and the air outlet 203 are in a ventilation state, so that an air flow may be driven by the fan 3 to pass through the heat dissipation housing 2, and then exchange heat with the heat-generating component 6, to form air-cooling heat dissipation. In some other scenarios, the heat-generating component 6 generates little heat, and the heat may be dissipated to the external environment through the device housing 1. The air inlet 202 and the air outlet 203 do not need to be opened for air-cooling heat dissipation. In the foregoing scenario, to ensure dustproof and waterproof performance of the electronic device, the air inlet 202 and the air outlet 203 may be in a sealed state, to prevent micro-dust, water vapor, and the like from entering the electronic device.

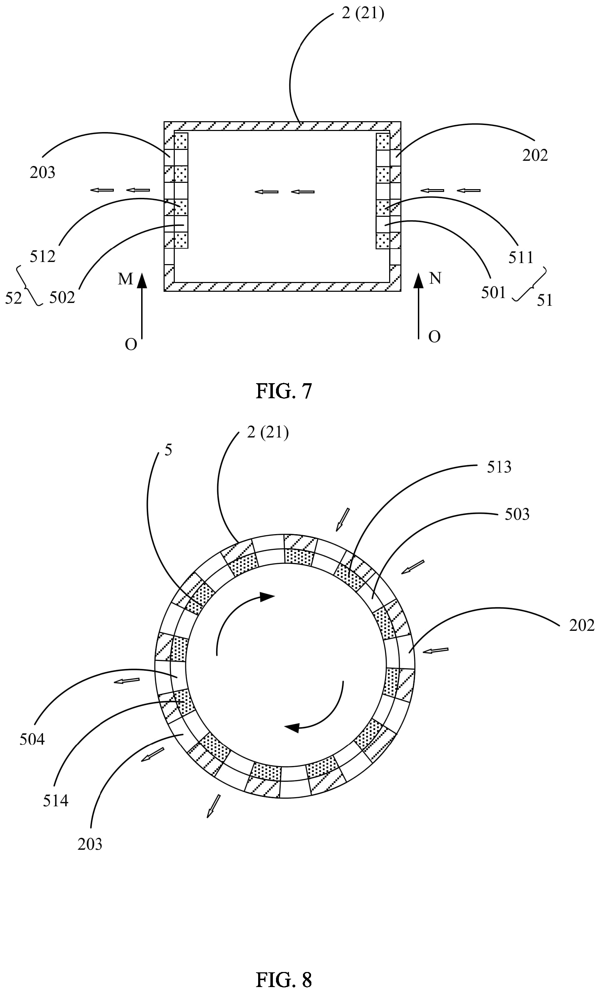

FIG. 7 is a diagram of a combination of a sealing member and a heat dissipation housing according to an embodiment of this application. As shown in FIG. 7, in an embodiment, the electronic device further includes a sealing member 5, and the sealing member 5 is movably connected to the heat dissipation housing 2. The sealing member 5 and the heat dissipation housing 2 can move relative to each other, so that relative positions of the sealing member 5 and the heat dissipation housing 2 change, and the air inlet 202 and the air outlet 203 are in a ventilation state or a sealed state. When the air inlet 202 and the air outlet 203 are in the ventilation state, an air flow in an external environment may enter the air duct 201 through the air inlet 202, and may flow out of the air duct 201 through the air outlet 203. When the air inlet 202 and the air outlet 203 are in the sealed state, an air flow in an external environment cannot enter the air duct 201 through the air inlet 202, and an air flow in the air duct 201 cannot flow out through the air outlet 203 either.

During specific implementation, the sealing member 5 is movably connected to the heat dissipation housing 2, and the sealing member 5 and the heat dissipation housing 2 have a first position relationship and a second position relationship. When the sealing member 5 and the heat dissipation housing 2 are in the first position relationship, the sealing member 5 may avoid at least a part of the air inlet 202 and at least a part of the air outlet 203, so that the air inlet 202 and the air outlet 203 are in the ventilation state. In other words, when the sealing member 5 and the heat dissipation housing 2 are in the first position relationship, at least a part of the air inlet 202 is not sealed by the sealing member 5, so that the air duct 201 can communicate with the external environment; and at least a part of the air outlet 203 is not sealed by the sealing member 5, so that the air duct 201 can communicate with the external environment. When the sealing member 5 and the heat dissipation housing 2 are in the second position relationship, the sealing member 5 may completely seal the air inlet 202 and the air outlet 203, so that the air inlet 202 and the air outlet 203 are in the sealed state. In a process of using the electronic device, a position relationship between the sealing member 5 and the heat dissipation housing 2 may be adjusted based on a specific application scenario, so that the air inlet 202 and the air outlet 203 are switched between the ventilation state and the sealed state. For example, in a scenario in which the heat-generating component 6 generates a large amount of heat, the sealing member 5 and the heat dissipation housing 2 may be adjusted to the first position relationship, so that the air inlet 202 and the air outlet 203 are in the ventilation state, to perform air-cooling heat dissipation on the heat-generating component 6. In a scenario in which the heat-generating component 6 generates a small amount of heat, the sealing member 5 and the heat dissipation housing 2 may be adjusted to the second position relationship, so that the air inlet 202 and the air outlet 203 are in the sealed state, to improve dustproof and waterproof performance of the electronic device.

When a connection relationship between the sealing member 5 and the heat dissipation housing 2 is specifically set, the sealing member 5 may be slidably connected to the heat dissipation housing 2, or the sealing member 5 may be rotatably connected to the heat dissipation housing 2, or the sealing member 5 and the heat dissipation housing 2 may be connected to each other in another form. This is not limited in this application. When a drive form of the sealing member 5 and the heat dissipation housing 2 is specifically set, the sealing member 5 and the heat dissipation housing 2 may be set to be in manual driving, to be specific, an acting force may be applied to the sealing member 5 or the heat dissipation housing 2 manually, so that the sealing member 5 and the heat dissipation housing 2 move relative to each other. A drive component may alternatively be disposed, so that the drive component is connected to the sealing member 5, or the drive component is connected to the heat dissipation housing 2, so that the sealing member 5 and the heat dissipation housing 2 move relative to each other under driving of the drive component.

For the sealing member 5, the sealing member 5 includes a plurality of possible structures. For example, the sealing member 5 may be a bar-shaped structure or a ring-shaped structure. Certainly, the sealing member 5 may alternatively be of another structure, which is not listed one by one in this application.

As shown in FIG. 7, in an embodiment, the heat dissipation housing 2 has a plurality of air inlets 202, and the plurality of air inlets 202 are spaced apart in a first direction OM. The sealing member 5 includes a first sealing member 51, the first sealing member 51 is movably connected to the heat dissipation housing 2, and the first sealing member 51 is configured to avoid the plurality of air inlets 202 or seal the plurality of air inlets 202. When the first sealing member 51 is specifically disposed, the first sealing member 51 includes a plurality of possible structures. In a possible structure, the first sealing member 51 also extends in the first direction OM, the first sealing member 51 has a plurality of first air vents 501 in the first direction OM, and there is a first spacer 511 between two adjacent first air vents 501. The first sealing member 51 may be specifically of a first bar-shaped structure. An extension direction of the first bar-shaped structure and an arrangement direction of the air inlet 202 are the same, and both are the first direction OM. In addition, the first bar-shaped structure further has a first air vent 501 and a first spacer 511 that are alternately disposed in the first direction OM.

Specifically, when the ventilation state and the sealed state of the air inlet 202 are switched, the first sealing member 51 may be slidably connected to the heat dissipation housing 2 in the first direction OM, so that the first sealing member 51 and the heat dissipation housing 2 can slide relative to each other in the first direction OM. In a sliding process, a position relationship between the first sealing member 51 and the heat dissipation housing 2 changes, and the first air vent 501 and the air inlet 202 may have an overlapping region, or may not have an overlapping region. Specifically, when the sealing member 5 and the heat dissipation housing 2 have the first position relationship, the first air vent 501 and the air inlet 202 at least partially overlap. In this case, an air flow in an external environment may be driven by the fan 3 to enter the heat dissipation housing 2 through an overlapping part between the first air vent 501 and the air inlet 202, so that the air inlet 202 is in the ventilation state. When the sealing member 5 and the heat dissipation housing 2 have the second position relationship, the first air vent 501 and the air inlet 202 are completely staggered. In this case, the first spacer 511 seals the air inlet 202. The first spacer 511 isolates the internal environment of the heat dissipation housing 2 from the external environment, so that the air inlet 202 is in the sealed state.

Still refer to FIG. 7. In the foregoing embodiment, the heat dissipation housing 2 also has a plurality of air outlets 203, and the plurality of air outlets 203 are spaced apart in a second direction ON. In addition to the first sealing member 51, the sealing member 5 further includes a second sealing member 52. A function of the second sealing member 52 is similar to a function of the first sealing member 51. Specifically, the second sealing member 52 is configured to avoid the plurality of air outlets 203 of the heat dissipation housing 2 or seal the plurality of air outlets 203 of the heat dissipation housing 2.

When the second sealing member 52 is specifically disposed, the second sealing member 52 includes a plurality of possible structures. In a possible structure, the second sealing member 52 extends in the second direction ON, the second sealing member 52 has a plurality of second air vents 502 in the second direction ON, and there is a second spacer 512 between two adjacent second air vents 502. The second sealing member 52 may be specifically of a second bar-shaped structure. An extension direction of the second bar-shaped structure and an arrangement direction of the air outlet 203 are the same, and both are the second direction ON. In addition, the second bar-shaped structure further has a second air vent 502 and a second spacer 512 that are alternately disposed in the second direction ON.

Specifically, when the ventilation state and the sealed state of the air outlet 203 are switched, the second sealing member 52 may be slidably connected to the heat dissipation housing 2 in the second direction ON, so that the second sealing member 52 and the heat dissipation housing 2 can slide relative to each other in the second direction ON. In a sliding process, a position relationship between the second sealing member 52 and the heat dissipation housing 2 changes, and the second air vent 502 and the air outlet 203 may have an overlapping region, or may not have an overlapping region. Specifically, when the sealing member 5 and the heat dissipation housing 2 have the first position relationship, the second air vent 502 and the air outlet 203 at least partially overlap, so that the air outlet 203 is in the ventilation state. When the sealing member 5 and the heat dissipation housing 2 have the second position relationship, the second air vent 502 and the air outlet 203 are completely staggered. In this case, the second spacer 512 seals the air outlet 203, so that the air outlet 203 is in the sealed state.

The first direction OM and the second direction ON may be a same direction, or may be different directions. In the embodiment shown in FIG. 6, the first direction OM and the second direction ON are same directions. The heat dissipation housing 2 is of a rectangular structure, and the air inlet 202 and the air outlet 203 are provided on two opposite sides of the heat dissipation housing 2. The air flow maybe driven by the fan 3 to flow in an opposite direction and pass through the heat dissipation housing 2, thereby helping reduce wind resistance and shorten a flow path of the air flow.

In the foregoing sealing member 5, the first sealing member 51 and the second sealing member 52 may be independent of each other, or may be integrally connected through a connection component, to implement synchronous movement. The first sealing member 51 and the second sealing member 52 are integrally connected through the connection component, so that the air inlet 202 and the air outlet 203 can be synchronously switched to the ventilation state, or the air inlet 202 and the air outlet 203 can be synchronously switched to the sealed state. In this way, the air inlet 202 and the air outlet 203 are in a consistent state. During specific implementation, the first sealing member 51 and the second sealing member 52 may share one set of drive components, thereby reducing a quantity of disposed drive components, improving control precision, and saving occupied space.

It should be noted that, in the foregoing embodiment, the heat dissipation housing 2 may have one air duct 201, or may have a plurality of air ducts 201. When the heat dissipation housing 2 has one air duct 201, one end of the air duct 201 has a plurality of air inlets 202, and the plurality of air inlets 202 are spaced apart in the first direction OM. The other end of the air duct 201 has a plurality of air outlets 203, and the plurality of air outlets 203 are spaced apart in the second direction ON. The first sealing member 51 may seal or avoid the air inlet 202 of the air duct 201, and the second sealing member 52 may seal or avoid the air outlet 203 of the air duct 201. When the heat dissipation housing 2 has a plurality of air ducts 201, each air duct 201 may have one or more air inlets 202, and may have one or more air outlets 203. In addition, the air inlets 202 of the plurality of air ducts 201 are spaced apart in the first direction OM, and the air outlets 203 of the plurality of air ducts 201 are spaced apart in the second direction ON. The first sealing member 51 may seal or avoid the air inlets 202 of the plurality of air ducts 201 at the same time, and the second sealing member 52 may seal or avoid the air outlets 203 of the plurality of air ducts 201 at the same time.

FIG. 8 is a diagram of another combination of a sealing member and a heat dissipation housing according to an embodiment of this application. As shown in FIG. 8, in an embodiment, the heat dissipation housing 2 has a first central axis, and the air inlet 202 and the air outlet 203 are provided around the first central axis in a circumferential direction. Specifically, the heat dissipation housing 2 includes a side wall 21 and a top wall 22, and the air inlet 202 and the air outlet 203 are located in the side wall 21. The sealing member 5 is of a ring-shaped structure, and the ring-shaped structure is disposed around the first central axis. The ring-shaped structure has a plurality of air vents, the plurality of air vents are sequentially spaced apart in the circumferential direction, and there is a spacer between two adjacent air vents.

Specifically, when a ventilation state and a sealed state of the air inlet 202 are switched, the sealing member 5 may be rotatably connected to the heat dissipation housing 2, so that the sealing member 5 and the heat dissipation housing 2 can rotate relative to each other around the first central axis. In a process in which the sealing member 5 and the heat dissipation housing 2 rotate relative to each other around the first central axis, a position relationship between the sealing member 5 and the heat dissipation housing 2 changes, and an overlapping status of the air vent and the air inlet 202 and an overlapping status of the air vent and the air outlet 203 also change. Still refer to the embodiment shown in FIG. 8. The plurality of air vents include a third air vent 503 and a fourth air vent 504, and the spacer includes a third spacer 513 and a fourth spacer 514. When the sealing member 5 and the heat dissipation housing 2 are in a first position relationship, the third air vent 503 and the air inlet 202 at least partially overlap, so that the air inlet 202 is in a ventilation state. In addition, the fourth air vent 504 and the air outlet 203 at least partially overlap, so that the air outlet 203 is in the ventilation state. When the sealing member 5 and the heat dissipation housing 2 are in a second position relationship, the third air vent 503 and the air inlet 202 are completely staggered. In this case, the third spacer 513 seals the air inlet 202, so that the air inlet 202 is in a sealed state. In addition, the fourth air vent 504 and the air outlet 203 are completely staggered. In this case, the fourth spacer 514 seals the air outlet 203, so that the air outlet 203 is in the sealed state.

In a process in which the sealing member 5 and the heat dissipation housing 2 rotate relative to each other, any air vent may at least partially overlap the air inlet 202 at a moment, or may at least partially overlap the air outlet 203 at a moment. Therefore, the third air vent 503 and the fourth air vent 504 generally refer to two different air vents, and are not specified as two specific air vents. Similarly, any spacer may be configured to seal the air inlet 202 or the air outlet 203 at a moment. Therefore, the third spacer 513 and the fourth spacer 514 are generally two different spacers, and are not specified as two specific spacers.

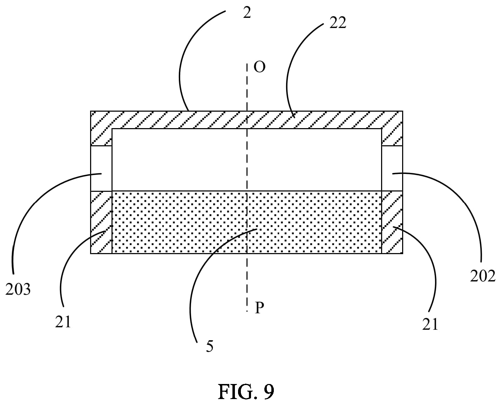

FIG. 9 is diagram of another combination of a sealing member and a heat dissipation housing according to an embodiment of this application. As shown in FIG. 9, in an embodiment, a structure of the heat dissipation housing 2 and a structure of the heat dissipation housing 2 shown in FIG. 8 are basically the same, and both have a first central axis OP. The air inlet 202 and the air outlet 203 are provided around the first central axis OP in a circumferential direction. In addition, the air inlet 202 and the air outlet 203 may be specifically located in the side wall 21 of the heat dissipation housing 2. A structure of the sealing member 5 is the same as and different from a structure of the sealing member 5 shown in FIG. 8. The same lies in that both the sealing member 5 and the blocking member 5 in FIG. 8 are ring-shaped structures, and the ring-shaped structures are disposed around the first central axis OP. A difference lies in that, in the embodiment shown in FIG. 9, the ring-shaped structure does not have an air vent. Based on different structures, the ring-shaped structure and the heat dissipation housing 2 may be slidably connected to each other along the first central axis OP. In other words, a relative motion form of the ring-shaped structure and the heat dissipation housing 2 is lifting motion along the first central axis OP, so that when the sealing member 5 and the heat dissipation housing 2 have the first position relationship, the ring-shaped structure may avoid the air inlet 202 and the air outlet 203; and when the sealing member 5 and the heat dissipation housing 2 have the second position relationship, the ring-shaped structure may seal the air inlet 202 and the air outlet 203.

In the foregoing embodiment, the sealing member 5 may be staggered relative to a surface of the heat dissipation housing 2, and avoid or seal the air inlet 202 and the air outlet 203. Certainly, in addition to the foregoing connection manners, the sealing member 5 and the heat dissipation housing 2 may further have other connection manners, which are not listed one by one in this application.

In a specific structure of the heat dissipation housing 2, the heat dissipation housing 2 protrudes from a surface of the device housing 1, and a side that is of the heat dissipation housing 2 and that faces the device housing 1 has an accommodation cavity. The sealing member 5 may be located in the accommodation cavity, or may be located outside the accommodation cavity. In some embodiments, the sealing member 5 may be disposed in the accommodation cavity, so the sealing member 5 is not exposed to an external environment. This helps ensure cleanliness of a joint between the sealing member 5 and the heat dissipation housing 2, and ensures smooth relative movement between the sealing member 5 and the heat dissipation housing 2. In addition, disposing the sealing member 5 in the heat dissipation housing 2 further can improve appearance effect of the electronic device.

In the foregoing embodiment, to drive the sealing member 5 and the heat dissipation housing 2 to move relative to each other, the electronic device may further include a drive component, and the drive component is connected to the sealing member 5. The drive component is configured to drive the sealing member 5 to move, so that the sealing member 5 avoids the air inlet 202 and the air outlet 203, or the sealing member 5 seals the air inlet 202 and the air outlet 203. In a specific embodiment, the drive component includes a motor, and the motor may provide a driving force to drive the sealing member 5 and the heat dissipation housing 2 to move relative to each other. A type of the motor is not limited. The motor may be a linear motor, and the linear motor may drive the sealing member 5 to perform linear motion relative to the heat dissipation housing 2. The motor may alternatively be a rotary motor, and a transmission member may be disposed between the rotary motor and the sealing member 5. In an embodiment, the transmission member may conduct torque of the motor to the sealing member 5, so that the sealing member 5 may rotate relative to the heat dissipation housing 2. In another embodiment, the transmission member may alternatively convert torque of the motor into thrust or a pulling force, so that the sealing member 5 may perform linear motion relative to the heat dissipation housing 2.

In some embodiments, the electronic device may further include a controller, and the controller is connected to the drive component and the fan 3. In some scenarios in which air-cooling heat dissipation needs to be performed on the heat-generating component 6, the controller may be configured to control the drive component to drive the sealing member 5 and the heat dissipation housing 2 to move relative to each other, so that the sealing member 5 and the heat dissipation housing 2 are in the first position relationship, and the air inlet 202 and the air outlet 203 are correspondingly in a ventilation state. In addition, in the foregoing scenario, the controller may be further configured to control the fan 3 to start, to provide power for flowing of an air flow. On the contrary, when air-cooling heat dissipation does not need to be performed on the heat-generating component 6, the controller may be configured to control the drive component to drive the sealing member 5 and the heat dissipation housing 2 to move relative to each other, so that the sealing member 5 and the heat dissipation housing 2 are in the second position relationship, and the air inlet 202 and the air outlet 203 are correspondingly in a sealed state. In addition, the controller may be further configured to control the fan 3 to be turned off.

Specifically, different trigger conditions may be set to trigger the controller, so that the controller controls the drive component and the fan 3 in the foregoing manner. For example, in a possible trigger manner, the electronic device further includes an operation part, and the operation part is connected to the controller. The operation part has a first trigger state and a second trigger state. When the heat-generating component 6 needs to perform air-cooling heat dissipation, the operation part may be in the first trigger state. When the heat-generating component 6 does not need to perform air-cooling heat dissipation, the operation part may be in the second trigger state. The controller is configured to: when the operation part is in the first trigger state, control the drive component to drive the heat dissipation housing 2 and the sealing member 5 to move relative to each other, so that the heat dissipation housing 2 and the sealing member 5 are in the first position relationship, and the fan 3 is started. In this case, both the air inlet 202 and the air outlet 203 of the heat dissipation housing 2 are in the ventilation state. An air flow may be driven by the fan 3 to enter the heat dissipation housing 2, to cool the heat-generating component 6. The controller is further configured to: when the operation part is in the second trigger state, control the drive component to drive the heat dissipation housing 2 and the sealing member 5 to move relative to each other, so that the heat dissipation housing 2 and the sealing member 5 are in the second position relationship, and the fan 3 is turned off. In this case, both the air inlet 202 and the air outlet 203 of the heat dissipation housing 2 are in the sealed state, to prevent external water vapor, dust, and the like from entering the heat dissipation housing 2, so that waterproof and dustproof effect is achieved.

When the operation part is specifically disposed, the operation part includes a plurality of possible forms. For example, the operation part may be a control button located on a housing frame, and the first trigger state and the second trigger state of the operation part may be switched by pressing a control bar. For another example, the operation part may alternatively be a control window located on a touchscreen of the electronic device, and the first trigger state and the second trigger state of the operation part are switched by tapping the control window.

For another example, in another possible trigger manner, the electronic device further includes a detection component, and the detection component is connected to the controller. Specifically, the detection component is configured to detect a first running indicator of the heat-generating component 6. The first running indicator includes but is not limited to a power consumption indicator or a temperature indicator of the heat-generating component 6. The controller is configured to: when the first running indicator is greater than a first threshold, control the drive component to drive the heat dissipation housing 2 and the sealing member 5 to move relative to each other, so that the heat dissipation housing 2 and the sealing member 5 are in the first position relationship, and the fan 3 is started. In this case, both the air inlet 202 and the air outlet 203 of the heat dissipation housing 2 are in the ventilation state. An air flow may be driven by the fan 3 to enter the heat dissipation housing 2, to cool the heat-generating component 6. In addition, the controller is further configured to: when the first running indicator is less than or equal to the first threshold, control the drive component to drive the heat dissipation housing 2 and the sealing member 5 to move relative to each other, so that the heat dissipation housing 2 and the sealing member 5 are in the second position relationship, and the fan 3 is turned off. In this case, both the air inlet 202 and the air outlet 203 of the heat dissipation housing 2 are in the sealed state, to prevent external water vapor, dust, and the like from entering the heat dissipation housing 2, so that waterproof and dustproof effect is achieved.

For another example, in another possible trigger manner, the heat-generating component 6 may alternatively be specifically a chip, and the chip is configured to carry running of a first application. The first application includes but is not limited to an application such as three-dimensional modeling, a game, or video editing. The first application has a running state and a stop state. When the first application is in the running state, power consumption of the chip increases, heat generation of the chip increases, and a temperature rises.

The controller is configured to: when the first application is in the running state, control the drive component to drive the heat dissipation housing 2 and the sealing member 5 to move relative to each other, so that the heat dissipation housing 2 and the sealing member 5 are in the first position relationship, and the fan 3 is started. In this case, both the air inlet 202 and the air outlet 203 of the heat dissipation housing 2 are in the ventilation state. An air flow may be driven by the fan 3 to enter the heat dissipation housing 2, to cool the heat-generating component 6. In addition, the controller is further configured to: when the first application is in a closed state, control the drive component to drive the heat dissipation housing 2 and the sealing member 5 to move relative to each other, so that the heat dissipation housing 2 and the sealing member 5 are in the second position relationship, and the fan 3 is turned off.

When the electronic device is being used, when any one of "the operation part is in the first trigger state", "the detection component detects that the first running indicator is greater than the first threshold", and "the first application is in the running state" is met, the controller may control the drive component, so that the drive component drives the heat dissipation housing 2 and the sealing member 5 to move relative to each other. In this way, the heat dissipation housing 2 and the sealing member 5 are in the first position relationship, and the fan 3 is started, to perform air-cooling heat dissipation on the heat-generating component 6. When "the operation part is in the second trigger state", "the detection component detects that the first running indicator is less than or equal to the first threshold", and "the first application is in the closed state" are satisfied at the same time, the controller may control the drive component, so that the drive component drives the heat dissipation housing 2 and the sealing member 5 to move relative to each other. In this way, the heat dissipation housing 2 and the sealing member 5 are in the second position relationship, and the fan 3 is turned off, to stop air-cooling heat dissipation on the heat-generating component 6.

It is clear that a person skilled in the art can make various modifications and variations to this application without departing from the scope of this application. This application is intended to cover these modifications and variations of this application provided that they fall within the scope of protection defined by the following claims and their equivalent technologies.

## Claims

1. An electronic device, comprising a device housing, a heat dissipation housing, a sealing member, a fan, and a heat-generating component, wherein
the heat dissipation housing is disposed on the device housing, the heat dissipation housing has an air duct, and the air duct has an air inlet and an air outlet; and the fan is disposed facing the air duct;
the sealing member is movably connected to the heat dissipation housing, and the sealing member and the heat dissipation housing have a first position relationship and a second position relationship; when the sealing member and the heat dissipation housing are in the first position relationship, the sealing member avoids at least a part of the air inlet and at least a part of the air outlet; and when the sealing member and the heat dissipation housing are in the second position relationship, the sealing member seals the air inlet and the air outlet; and
the heat-generating component is located in the device housing, and the heat-generating component is thermally connected to the air duct.

2. The electronic device according to claim 1, wherein the electronic device further comprises a thermal conduction component, the thermal conduction component is thermally connected to the heat-generating component, and the thermal conduction component is at least partially located in the air duct.

3. The electronic device according to claim 1 or 2, wherein the heat dissipation housing has a plurality of air ducts, and each air duct is provided with at least one fan; and
the plurality of air ducts comprise a first air duct and a second air duct, the first air duct and the second air duct have a same air inlet, and the first air duct and the second air duct have different air outlets; or
the first air duct and the second air duct have different air inlets, and the first air duct and the second air duct have a same air outlet; or
the first air duct and the second air duct have different air inlets, and the first air duct and the second air duct have different air outlets.

4. The electronic device according to any one of claims 1 to 3, wherein a plurality of partition plates are disposed in the heat dissipation housing, and the air duct is enclosed by the plurality of partition plates; or a ventilation pipe is disposed in the heat dissipation housing, and the ventilation pipe forms the air duct.

5. The electronic device according to any one of claims 1 to 4, wherein the heat dissipation housing protrudes from a surface of the device housing, and a transparent window is disposed on a wall surface of the heat dissipation housing; and the electronic device further comprises a camera module, the camera module has a light incident surface, and a projection of at least a part of the light incident surface in a third direction is located in a projection of the transparent window in the third direction; and
the third direction is perpendicular to a plane on which the transparent window is located.

6. The electronic device according to any one of claims 1 to 5, wherein the heat dissipation housing protrudes from the surface of the device housing, the heat dissipation housing comprises a side wall and a top wall that are connected to each other, and the side wall is connected to the device housing; and
at least one of the air inlet and the air outlet is provided in the side wall.

7. The electronic device according to any one of claims 1 to 6, wherein there are a plurality of air inlets, and the plurality of air inlets are spaced apart in a first direction; and there are a plurality of air outlets, and the plurality of air outlets are spaced apart in a second direction;
the sealing member comprises a first sealing member and a second sealing member, the first sealing member extends in the first direction, the first sealing member has a plurality of first air vents in the first direction, and there is a first spacer between two adjacent first air vents; and the second sealing member extends in the second direction, the second sealing member has a plurality of second air vents in the second direction, and there is a second spacer between two adjacent second air vents; and
when the sealing member and the heat dissipation housing have the first position relationship, the air inlet and the first air vent at least partially overlap, and the air outlet and the second air vent at least partially overlap; and when the sealing member and the heat dissipation housing have the second position relationship, the first spacer seals the air inlet, and the second spacer seals the air outlet.

8. The electronic device according to any one of claims 1 to 6, wherein the heat dissipation housing has a first central axis, and the air inlet and the air outlet are arranged around the first central axis in a circumferential direction;
the sealing member is of a ring-shaped structure, and the ring-shaped structure is disposed around the first central axis; and the ring-shaped structure has a plurality of air vents, the plurality of air vents are sequentially spaced part in the circumferential direction, and there is a spacer between two adjacent air vents;
the plurality of air vents comprise a third air vent and a fourth air vent, and when the sealing member and the heat dissipation housing have the first position relationship, the third air vent and the air inlet at least partially overlap, and the fourth air vent and the air outlet at least partially overlap; and
the spacer comprises a third spacer and a fourth spacer, and when the sealing member and the heat dissipation housing have the second position relationship, the third spacer seals the air inlet, and the fourth spacer seals the air outlet.

9. The electronic device according to any one of claims 1 to 6, wherein the heat dissipation housing has a first central axis, and the air inlet and the air outlet are arranged around the first central axis in a circumferential direction; and the sealing member is of a ring-shaped structure, the ring-shaped structure is disposed around the first central axis, and the ring-shaped structure is slidably connected to the heat dissipation housing along the first central axis;
when the sealing member and the heat dissipation housing have the first position relationship, the ring-shaped structure avoids the air inlet and the air outlet; and
when the sealing member and the heat dissipation housing have the second position relationship, the ring-shaped structure seals the air inlet and the air outlet.

10. The electronic device according to any one of claims 1 to 9, wherein the electronic device further comprises a drive component, and the drive component is connected to the sealing member; and the drive component is configured to drive the sealing member to move, so that the sealing member avoids at least a part of the air inlet and at least a part of the air outlet, or the sealing member seals the air inlet and the air outlet.

11. The electronic device according to claim 10, wherein the electronic device further comprises a controller and an operation part, and the controller is separately connected to the operation part, the drive component, and the fan; and
the operation part has a first trigger state, and the controller is configured to: when the operation part is in the first trigger state, control the drive component to drive the sealing member to move relative to the heat dissipation housing, so that the heat dissipation housing and the sealing member are in the first position relationship, and the fan is started.

12. The electronic device according to claim 10 or 11, wherein the electronic device further comprises the controller and a detection component, and the controller is separately connected to the detection component, the drive component, and the fan;
the detection component is configured to detect a first running indicator of the heat-generating component; and
the controller is configured to: when the first running indicator is greater than a first threshold, control the drive component to drive the sealing member to move relative to the heat dissipation housing, so that the heat dissipation housing and the sealing member are in the first position relationship, and the fan is started.

13. The electronic device according to any one of claims 10 to 12, wherein the electronic device further comprises the controller, and the controller is separately connected to the drive component and the fan; and the heat-generating component is a chip, and the chip is configured to carry running of a first application; and
the controller is configured to: when the first application is in a running state, control the drive component to drive the sealing member to move relative to the heat dissipation housing, so that the heat dissipation housing and the sealing member are in the first position relationship, and the fan is started.

14. The electronic device according to any one of claims 10 to 13, wherein the electronic device further comprises the controller, the operation part, and the detection component, and the controller is separately connected to the operation part, the detection component, the drive component, and the fan;
the operation part has a second trigger state; and the detection component is configured to detect the first running indicator of the heat-generating component;
the heat-generating component is the chip, and the chip is configured to carry running of the first application; and
the controller is configured to: when the operation part is in the second trigger state, the first running indicator is less than or equal to the first threshold, and the first application is in a stop state, control the drive component to drive the sealing member to move relative to the heat dissipation housing, so that the heat dissipation housing and the sealing member are in the second position relationship, and the fan is turned off.

15. The electronic device according to any one of claims 1 to 14, wherein the electronic device further comprises a display, the display is disposed on the surface of the device housing, and the heat dissipation housing is located on a side that is of the device housing and that is away from the display.
